(19) 

Europäisches Patentamt
European Patent Office
Office européen des brevets

(11) **EP 2 043 264 A1**

(12) **EUROPÄISCHE PATENTANMELDUNG**

(43) Veröffentlichungstag:
 **01.04.2009 Patentblatt 2009/14**

(51) Int Cl.:
 ***H03H 17/04*** *(2006.01)*

(21) Anmeldenummer: **08013677.3**

(22) Anmeldetag: **30.07.2008**

(84) Benannte Vertragsstaaten:
 **AT BE BG CH CY CZ DE DK EE ES FI FR GB GR HR HU IE IS IT LI LT LU LV MC MT NL NO PL PT RO SE SI SK TR**
 Benannte Erstreckungsstaaten:
 **AL BA MK RS**

(30) Priorität: **26.09.2007 DE 102007046181**

(71) Anmelder: **Micronas GmbH**
 **79108 Freiburg (DE)**

(72) Erfinder: **Noeske, Carsten**
 **79350 Sexau (DE)**

(74) Vertreter: **Patentanwälte**
 **Westphal, Mussgnug & Partner**
 **Am Riettor 5**
 **78048 Villingen-Schwenningen (DE)**

(54) **CIC-Filter mit fraktionaler Integration**

(57) CIC-Filter (Cascaded-Integrator-Comb Filter) mit einer Reihenschaltung aus wenigstens einem Integrator (I), einer Dezimatiosstufe (R) und wenigstens einem Differenzierer (C), wobei dem ersten Integrator (I) eine Vorrichtung zur fraktionalen Integration (FI) parallelgeschaltet ist.

## Fig. 3

EP 2 043 264 A1

**Beschreibung**

Die Erfindung betrifft ein CIC-Filter (Cascaded-Integrator-Comb-Filter) gemäß den Merkmalen des Oberbegriffs des Patentanspruchs 1.

CIC-Filter sind auch unter der Bezeichnung MTA-Filter (Moving-Time-Average-Filter) bekannt. CIC-Filter werden u. a. im Stand der Technik zur Abtastratenreduktion eingesetzt, d.h. zur Bandbreitenreduktion bei gleichzeitiger Verringerung der Abtastrate um einen ganzzahligen Faktor R. Ein CIC-Filter zur Dezimierung eines eingangsseitigen Signaltaktes besteht dabei im einfachsten Fall aus einem Akkumulator, der immer R Samples aufaddiert, das Ergebnis alle R Takte ausgibt und dessen Inhalt dabei auf Null gesetzt wird. Dieses lässt sich formal als eine Reihenschaltung aus einem Integrator, einer Dezimationsstufe und einem Differenzierer beschreiben, wobei ein eingangsseitiges Signal dem Integrator zugeführt und von diesem ausgangsseitig der Dezimierungsstufe zur Verfügung gestellt wird. Die Dezimationsstufe verringert den Signaltakt um einen Faktor R, so dass gilt fout = fin/R, und führt das taktreduzierte Signal dem Differenzierer zu. Der Differenzierer verarbeitet das taktreduzierte Signal und stellt es ausgangsseitig zur Verfügung. Ein CIC-Filter höherer Ordnung enthält weitere Integratoren am Eingang und weitere Differenzierer am Ausgang. Bei derartigen CIC-Filtern ist es nachteilhaft, dass eine Taktreduzierung nur für ganzzahlige Werte von R möglich ist, d. h. dass von der Dezimierungsstufe ausgangsseitig jeder R-te eingangsseitige Abtastwert zur Verfügung gestellt wird.

Für Symboltaktregelungen in rein digitalen Demodulatoren für Kommunikationssysteme ist es vorteilhaft, eine Abtastung des eingangsseitigen Signals an den korrekten Symbolzeitpunkten, also auch zwischen zwei Abtastwerten zu realisieren. Zu diesem Zeitpunkt stehen jedoch keine Signalwerte zur Verfügung.

Aus dem Stand der Technik ist es bekannt, Zwischenwerte durch Interpolation zu gewinnen.

Bisher werden zur fraktionalen Interpolation Polyphasen-FIR-Filter (Finite Impulse Response Filter) verwendet, bei denen jede Polyphase einen Allpass approximiert; d. h. ein Filter, bei dem jeder n-te Abtastwert der Impulsantwort des Gesamtfilters verwendet wird. Eine Steuerungseinrichtung wählt dazu immer die Polyphase aus, die einem gewünschten Phasenversatz des Signals an jedem Ausgangswert entspricht. An diesem Verfahren ist jedoch nachteilig, dass die Koeffizienten eine relativ hohe Auflösung in Bits benötigen, um eine ausreichende Dämpfung zu erreichen. Diese hohe Auflösung bedingt große Multiplizierer zur Implementierung des Filters. Ein weiterer Nachteil ist, dass für ein derartiges Filter mehrere solche Multiplizierer benötigt werden und die Speicherung der Koeffizienten aufwendig ist.

In letzter Zeit werden zunehmend interpolierende FIR-Filter eingesetzt (IFIR-Filter), bei denen die Anzahl der Polyphasen dadurch reduziert wird, dass die finalen Interpolationskoeffizienten mittels Polynomen zwischen verschiedenen Polyphasen interpoliert werden. Dies reduziert zwar den Speicherbedarf für die Koeffizienten, erhöht aber die benötigte Rechenleistung und verkompliziert die Steuerung des Filters.

Es ist die Aufgabe der Erfindung, ein bekanntes CIC-Filter derart weiterzubilden, dass eine fraktionale Dezimation der Abtastrate in einfacher und effizienter Weise möglich ist.

Diese Aufgabe wird gelöst durch ein CIC-Filter mit den Merkmalen des Patentanspruchs 1.

Ein erfindungsgemäßes CIC-Filter weist eine Reihenschaltung aus wenigstens einem Integrator, einer Dezimationsstufe und wenigstens einem Differenzierer auf, wobei dem ersten Integrator eine Vorrichtung zur fraktionalen Integration parallel geschaltet ist. Es wird damit vorteilhaft ausgenutzt, dass der erste Integrator, der das Eingangssignal in einem definierten Zeitraum aufintegriert, analog betrachtet werden kann. Das erlaubt es, das Ergebnis der ersten Integration durch einen fraktionalen Anteil zu erweitern.

Bevorzugterweise enthält die Vorrichtung zur fraktionalen Integration eine Interpolationsschaltung sowie eine Zeitberechnungsschaltung zur Berechnung eines fraktionalen Zeitanteils. Durch eine derartige Ausgestaltung wird es ermöglicht, dass die Vorrichtung zur fraktionalen Integration einen zwischen zwei Abtastwerten interpolierten Signalverlauf über den fraktionalen Zeitanteil aufintegriert. Es wird so ermöglicht, der zeitdiskreten Integration des ersten Integrators einen fraktionalen Integrationsanteil hinzuzufügen.

Die Interpolationsschaltung ist dabei vorteilhafterweise als Schaltung zur konstanten Interpolation durch Halten des Wertes ("Sample & Hold") ausgebildet. Durch eine derartige Ausgestaltung ist es in besonders einfacher Weise möglich, den Signalverlauf anzunähern und eine fraktionale Integration mit nur einem zusätzlichen Multiplizierer im Signalpfad durchzuführen. Diesem Multiplizierer wird das Eingangssample sowie das Ausgangssignal der Zeitberechnungsschaltung zugeführt. Der fraktionale Integrationsanteil ist das Ergebnis der Multiplikation und wird dem letzten Ergebnis des diskreten Integrators aufaddiert.

In einer Weiterbildung der Erfindung ist eine Abtastvorrichtung vorgesehen, die das ausgangsseitige Signal der Parallelschaltung zu den Zeitpunkten, die mittels der Zeitberechnungsschaltung ermittelt werden, abtastet und ausgangsseitig zur Verfügung stellt. Durch eine derartige Abtastvorrichtung, die beispielsweise auch als Sample & Hold-Schaltung ausgestaltet sein kann, werden nach erfolgter franktionaler Integration die Ausgangswerte zu den korrekten Symbolzeitpunkten zur Verfügung gestellt und beispielsweise einem weiteren Integrator zugeführt. Ein derartiges Vorgehen ist sinnvoll, da die weiteren Integratoren des CIC-Filters auf diese Weise unabhängig vom ersten Integrator auf einem ganzzahligen Vielfachen der Abtastrate des Ausgangssignales arbeiten können.

Weitere Vorteile sowie bevorzugte Ausgestaltungsformen der Erfindung ergeben sich aus der nachfolgenden Beschreibung eines Ausführungsbeispiels unter Bezugnahme auf die beigefügten Figuren. Es zeigen:

Figur 1     ein CIC-Filter zur Dezimierung eines Symboltakts gemäß dem Stand der Technik,

Figur 2a     einen Integrator, wie er in einem CIC-Filter gemäß Figur 1 verwendet wird,

Figur 2b     einen Differenzierer, wie er in einem CIC-Filter gemäß Figur 1 verwendet wird,

Figur 3     ein Blockschaltbild eines erfindungsgemäßen CIC-Filters,

Figur 4     ein Ausführungsbeispiel des ersten Integrators eines erfindungsgemäßen CIC-Filters von Figur 3,

Figur 5     eine beispielhafte Signalfolge zur Verdeutlichung der Wirkungsweise eines erfindungsgemäßen CIC-Filters.

Figur 6     ein Ausführungsbeispiel des ersten Integrators eines erfindungsgemäßen CIC-Filters von Figur 3 basierend auf linearer Interpolation

Figur 7     eine beispielhafte Signalfolge zur Verdeutlichung der Wirkungsweise eines erfindungsgemäßen CIC-Filters basierend auf linearer Interpolation.

Soweit nicht anders angegeben bezeichnen gleiche Bezugszeichen identische oder funktionsgleiche Komponenten.

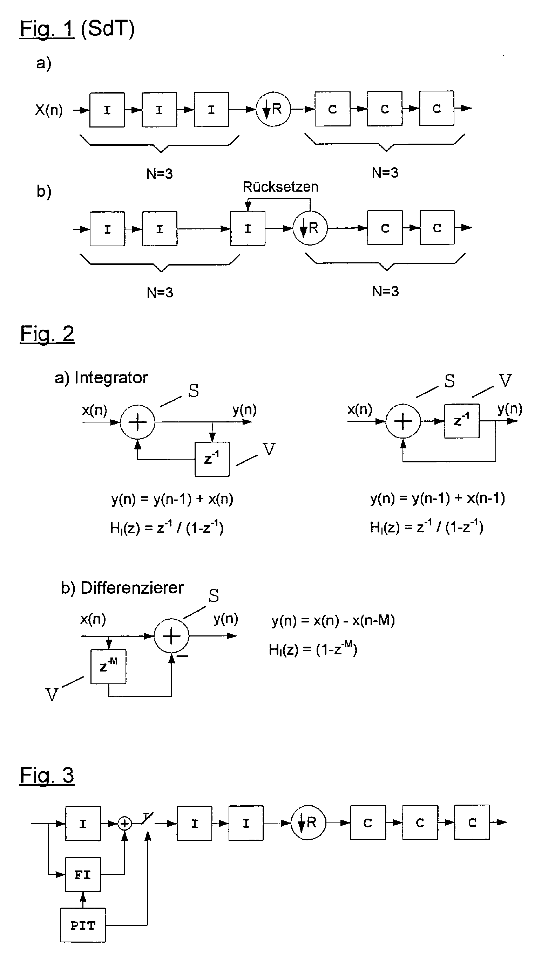

Figur 1 zeigt ein CIC-Filter nach dem Stand der Technik. Ein derartiges CIC-Filter ist im Allgemeinen aus einer Reihenschaltung von N Integratoren I, einer Dezimationsstufe R und N Differenzierern C aufgebaut. Wahlweise können die innere Kombination von Integrator, Dezimationsstufe und Differentiator als zurücksetzbarer Akkumulator ausgeführt sein. Das in Figur 1a dargestellte CIC-Filter zur Symboltaktdezimierung ist aus N = 3 Integratoren, einer Dezimierungsstufe R und N = 3 Differenzierern C aufgebaut. Ein eingangsseitiges Signal x[n] wird von den in Reihe geschalteten Integratoren I drei Mal integriert und der Dezimierungsstufe R zugeführt. Das ausgangsseitige Signal der Dezimierungsstufe R wird den Differenzierern C zugeführt und von diesen drei Mal differenziert und ausgangsseitig als Ausgangssignal $_Y$[n]ausgegeben. Bei einem derartigen CIC-Filter mit Dezimationsstufe R ist nachteilig, dass für eine Dezimierung des Symboltaktes lediglich das eingangsseitige Signal $_X$[n]zur Verfügung steht, welches nur aus diskreten Abtastzeitpunkten ermittelt wurde. Durch die Dezimierungsstufe R kann eine Reduzierung des Symboltaktes nur dadurch erfolgen, dass beispielsweise nur jeder dritte Abtastwert des eingangsseitigen Signals x[n] den ausgangsseitig angeordneten Differenzierern C zur Verfügung gestellt wird.

Figur 2a zeigt den Aufbau eines Integrators I, wie er in einem CIC-Filter gemäß Figur 1 zum Einsatz kommt. Ein diskreter Integrator I ist aus seinem Summierer S und einer Verzögerungsstufe V aufgebaut. Dem Summierer S wird das Eingangssignal $_x$[n] sowie das um einen Symboltakt verzögerte Ausgangssignal y[N - 1] zugeführt, so dass sich seine Funktionsweise durch die Gleichung

$$y[n] = y[n - 1] + x[N]$$

beschreiben lässt. Die Übertragungsfunktion $H_i(z)$ eines derartigen Integrators I ergibt sich entsprechend zu

$$H_I(z) = 1 : (1 - z^{-1}).$$

Vorzugsweise lässt sich das Verzögerungsglied auch im Signalpfad positionieren, wodurch ein schaltungstechnischer Vorteil hinsichtlich der Pfadlänge im Schaltungsdesign erreicht wird. Dadurch ergibt sich die Übertragungsfunktion des Integrators I zu

$$H_I(z) = z^{-1} : (1 - z^{-1}).$$

Figur 2b zeigt einen diskreten Differenzierer C, der aus einem Summierer S sowie einer Verzögerungsstufe V aufgebaut ist. Dem Summierer S werden eingangsseitig das Eingangssignal y[n]sowie das um M Taktperioden verzögerte Eingangssignal x[n-M] zugeführt, so dass ausgangsseitig ein Signal y[n] mit der Funktion

$$_Y[n] = X[n] - x[n-M]$$

abgegriffen werden kann. Bezogen auf den Takt der Integratoren I, der um Faktor R höher als der der Differenzierer ist, ergibt sich die Übertragungsfunktion $H_c(z)$ des Differenzierers D entsprechend zu

$$H_C(z) = 1 - z^{-RM}.$$

M bezeichnet in diesen Gleichungen die Anzahl der Verzögerungstakte und ist in der Regel 1 oder 2, wobei R den Dezimierungsfaktor der Dezimierungsstufe darstellt.

Figur 3 zeigt ein Blockschaltbild eines erfindungsgemäßen CIC-Filters mit beispielhaft N = 3 Integratoren I, einer Dezimierungsstufe R sowie beispielhaft N = 3 Differenzierern C, wobei dem ersten eingangsseitigen Integrator I eine Vorrichtung zur fraktionalen Integration FI parallel geschaltet ist.

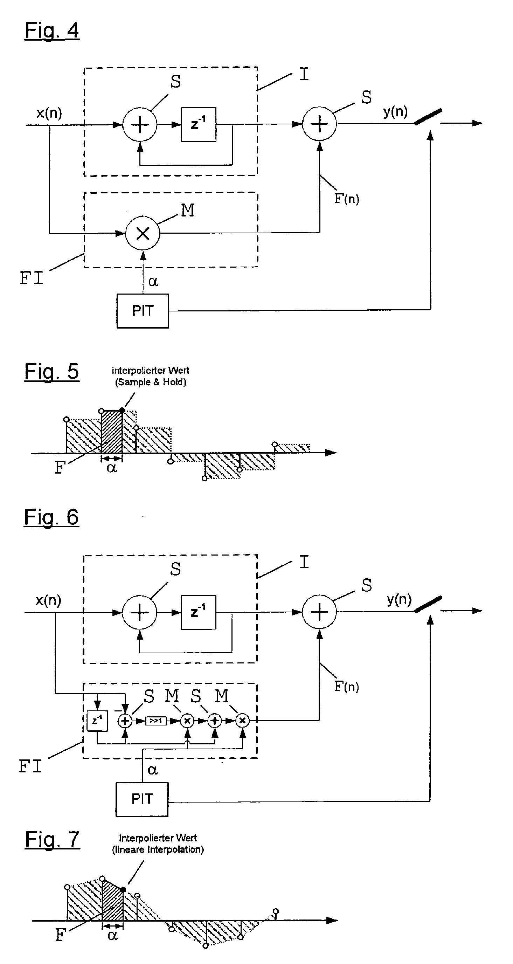

Figur 4 zeigt den ersten in Figur 3 links dargestellten Schaltungsteil, nämlich die Parallelschaltung des ersten Integrators I sowie der Vorrichtung zur fraktionalen Integration FI in einer erfindungsgemäßen Ausgestaltungsform. Das eingangsseitige Signal x[n] wird dem ersten Integrator I des CIC-Filters sowie der parallel geschalteten Vorrichtung zur fraktionalen Integration FI zugeführt. Die Vorrichtung zur fraktionalen Integration FI basiert in diesem Beispiel auf einer Sample & Hold-Interpolation , so dass sie nur aus einem Multiplizierer M aufgebaut ist. Dem Multiplizierer M wird eingangsseitig das Eingangssignal sowie das Ausgangssignal einer Zeitberechnungsschaltung PIT zugeführt. Die Zeitberechnungsschaltung PIT stellt einen fraktionalen Zeitanteil $\alpha$, der die Abweichung des gewünschten Abtastzeitpunktes vom Symboltakt darstellt zur Verfügung. Es wird also durch den Multiplizierer M ausgangsseitig ein fraktionaler Integrationsanteil zur Verfügung gestellt, der graphisch betrachtet einem Rechteck der Höhe des letzten Signalwerts mit der Breite $\alpha$ entspricht. Dieser fraktionale Integrationsanteil sowie das ausgangsseitige Signal des ersten Integrators I werden einem Summierer S zugeführt, welcher ausgangsseitig die Summe aus dem regulär aufintegrierten Eingangssignal x[n] sowie dem fraktionalen Integrationsanteil ausgibt. Diese Summe wird beispielsweise über einen von der Zeitberechnungsschaltung PIT gesteuerten Abtaster dem folgenden Integrierer I (der in Figur 4 nicht mehr dargestellt ist) zur Verfügung gestellt. Vorteilhafterweise leitet der Abtaster alle Samples, bei denen die Zeitberechnungschaltung vom neuen fraktionalen Zeitanteil $\alpha$ einen ganzzahligen Anteil abgetrennt hat, nicht an die folgenden Schaltungsteile weiter.

Figur 5 zeigt eine beispielhafte Signalfolge x[n], die zu diskreten Zeitpunkten abgetastet wurde. Des Weiteren sind in Figur 5 die Ausgangswerte y[n] des Integrators I zu eben diesen Zeitpunkten eingezeichnet. Soll das eingangsseitige Signal x[n] zur Dezimation des Symboltaktes zu Zeitpunkten abgetastet werden, zu denen kein diskretes Signal vorliegt, existiert kein korrekter Wert für das Ausgangssignal y[n] des Integrators I. In dem dargestellten Beispiel wird zur Berechnung eines interpolierten Zwischenwertes für das Integral eine konstante Interpolation mittels einer Sample & Hold-Schaltung S&H verwendet. Grafisch betrachtet wird für einen Abtastzeitpunkt n + $\alpha$ zum letzten gültigen Ausgangswert $_y$[n] des Integrators I ein fraktionaler Anteil F = x[n] · $\alpha$, also das schraffiert eingezeichnete Rechteck, hinzugezählt. Durch dieses Vorgehen wird ein weiterer gültiger Ausgangswert für das Integral erzeugt, der je nach Interpolationsmethode eine gute Annäherung an den tatsächlichen Wert des Integrals zu diesem Zeitpunkt ist. Je nach Eigenschaften des Eingangssignals sind auch höhere Interpolationsmethoden, z. B. eine lineare Interpolation, sinnvoll.

Figur 6 und 7 zeigt eine beispielhafte Ausgestaltung der Erfindung basierend auf linearer Interpolation.

Figur 6 zeigt im Wesentlichen eine Schaltung gemäß Figur 4, wobei jedoch die Vorrichtung zur fraktionalen Interpolation FI für eine lineare Interpolation ausgebildet ist. Das eingangsseitige Signal x[n] ist einer Verzögerungsstufe sowie mit negativem Vorzeichen einem ersten Summierer S zuführbar. Dem ersten Summierer S ist des Weiteren das Ausgangssignal der Verzögerungsstufe angelegt. Das Ausgangssignal des ersten Summierers S wird mit dem fraktionalen Zeitanteil $\alpha$ multipliziert und anschließend zum Ausgangssignal der Verzögerungsstufe addiert. Das Ausgangssignal des zweiten Summierers wird ein weiteres Mal mit dem fraktionalen Zeitanteil $\alpha$ multipliziert und anschließend dem Summierer S, der dem ersten Integrator nachgeschaltet ist, zugeführt.

Figur 7 veranschaulicht die durch die in Figur 6 dargestellte lineare Interpolation anhand einer Folge von Abtastwerten.

Bezugszeichenliste

| I | Integrator |
|---|---|
| C | Differenzierer |
| R | Dezimationsstufe |
| S | Summierer |
| M | Multiplizierer |
| FI | Vorrichtung zur fraktionalen Integration |
| PIT | Zeitberechnungsschaltung |
| $\alpha$ | fraktionaler Zeitanteil |
| F(n) | fraktionaler Integrationsanteil |
| x[n] | Eingangssignal |
| y[n] | Ausgangssignal |
| S&H | Sample & Hold-Schaltung |
| H | Übertragungsfunktion |

**Patentansprüche**

1. CIC-Filter (Cascaded-Integrator-Comb Filter) mit einer Reihenschaltung aus wenigstens einem Integrator (I), einer Dezimatiosstufe (R) und wenigstens einem Differenzierer (C),
   **dadurch gekennzeichnet, dass**
   dem ersten Integrator (I) eine Vorrichtung zur fraktionalen Integration (FI) parallelgeschaltet ist.

2. CIC-Filter nach Anspruch 1,
   **dadurch gekennzeichnet, dass** die Dezimationsstufe (R) als rücksetzbarer Akkumulator ausgeführt ist.

3. CIC-Filter nach Anspruch 1 oder 2,
**dadurch gekennzeichnet, dass**
der Vorrichtung zur fraktionalen Integration (FI) ein Ausgangssignal einer Zeitberechnungsschaltung (PIT) zur Berechnung eines fraktionalen Zeitanteils ($\alpha$) zuführbar ist.

4. CIC-Filter nach Anspruch 3,
**dadurch gekennzeichnet, dass**
der Vorrichtung zur fraktionalen Integration (FI) ein Eingangssignal (x[n]) zuführbar ist.

5. CIC-Filter nach Anspruch 4,
**dadurch gekennzeichnet, dass**
die Vorrichtung zur fraktionalen Integration (FI) derart ausgebildet ist, dass sie die Fläche (F) unter einem interpolierten Signal zwischen einem Eingangswert und einem zweiten Wert approximiert.

6. CIC-Filter nach Anspruch 5,
**dadurch gekennzeichnet, dass**
der zweite Wert ein interpolierter Wert entsprechend dem fraktionalen Zeitanteil ($\alpha$) ist.

7. CIC-Filter nach einem der vorhergehenden Ansprüche,
**dadurch gekennzeichnet, dass**
die Vorrichtung zur fraktionalen Integration (FI) mindestens eine Skalierungsschaltung enthält.

8. CIC-Filter nach Anspruch 7,
**dadurch gekennzeichnet, dass**
mindestens ein Multiplizierer (M) vorgesehen ist, dem das Ausgangssignal der Zeitberechnungsschaltung (PIT) zuführbar ist.

9. CIC-Filter nach Anspruch 8,
**dadurch gekennzeichnet, dass** dem ersten Integrator (I) ein Summierer (S) nachgeschaltet ist, dem ein Ausgangssignal (F(n)) der Vorrichtung zur fraktionalen Integration zuführbar ist.

10. CIC-Filter nach einem der vorhergehenden Ansprüche,
**dadurch gekennzeichnet, dass**
eine Abtastvorrichtung vorgesehen ist, die das Ausgangsseitige Signal der Parallelschaltung zu den Zeitpunkten, die mittels der Zeitberechnungsschaltung (PIT) ermittelten werden, abtastet und ausgangsseitig zur Verfügung stellt.

Fig. 1 (SdT)

a)

$X(n) \rightarrow$ I $\rightarrow$ I $\rightarrow$ I $\rightarrow$ ↓R $\rightarrow$ C $\rightarrow$ C $\rightarrow$ C $\rightarrow$

N=3                    N=3

b)

Rücksetzen

$\rightarrow$ I $\rightarrow$ I $\rightarrow$ I $\rightarrow$ ↓R $\rightarrow$ C $\rightarrow$ C $\rightarrow$

N=3                    N=3

Fig. 2

a) Integrator

$x(n) \rightarrow$ (+) S $\rightarrow y(n)$ ... $z^{-1}$ V

$y(n) = y(n-1) + x(n)$

$H_I(z) = z^{-1} / (1-z^{-1})$

$x(n) \rightarrow$ (+) S $\rightarrow$ $z^{-1}$ V $\rightarrow y(n)$

$y(n) = y(n-1) + x(n-1)$

$H_I(z) = z^{-1} / (1-z^{-1})$

b) Differenzierer

$x(n) \rightarrow$ (+) S $\rightarrow y(n)$ ... $z^{-M}$ V ... $-$

$y(n) = x(n) - x(n-M)$

$H_I(z) = (1-z^{-M})$

Fig. 3

$\rightarrow$ I $\rightarrow$ (+) $\nearrow$ $\rightarrow$ I $\rightarrow$ I $\rightarrow$ ↓R $\rightarrow$ C $\rightarrow$ C $\rightarrow$ C $\rightarrow$

FI

PIT

Fig. 4

Fig. 5

interpolierter Wert
(Sample & Hold)

Fig. 6

Fig. 7

interpolierter Wert
(lineare Interpolation)

Europäisches
Patentamt

European
Patent Office

Office européen
des brevets

**EUROPÄISCHER RECHERCHENBERICHT**

Nummer der Anmeldung

EP 08 01 3677

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 7 196 648 B1 (DING LEI [US] ET AL) 27. März 2007 (2007-03-27) * Spalte 5, Zeile 61 - Spalte 11, Zeile 48; Abbildungen 5,6 * ----- | 1-10 | INV. H03H17/04 |
| A | US 2004/148319 A1 (BOSSMEYER THOMAS [DE] ET AL BOSSMEYER THOMAS [DE] ET AL) 29. Juli 2004 (2004-07-29) * Absatz [0047]; Abbildung 9 * ----- | 1-10 | |

RECHERCHIERTE
SACHGEBIETE (IPC)

H03H

Der vorliegende Recherchenbericht wurde für alle Patentansprüche erstellt

| Recherchenort | Abschlußdatum der Recherche | Prüfer |
|---|---|---|
| Den Haag | 13. Januar 2009 | Lecoutre, Renaud |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
    ..................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 08 01 3677

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-01-2009

| Im Recherchenbericht angeführtes Patentdokument | Datum der Veröffentlichung | Mitglied(er) der Patentfamilie | Datum der Veröffentlichung |
|---|---|---|---|
| US 7196648 B1 | 27-03-2007 | KEINE | |
| US 2004148319 A1 | 29-07-2004 | KEINE | |

Für nähere Einzelheiten zu diesem Anhang : siehe Amtsblatt des Europäischen Patentamts, Nr.12/82